# EUROPEAN PATENT APPLICATION

(11) **EP 1 507 284 A2**
(43) Date of publication of application: **16.02.2005**
(21) Application number: 04077280.8
(22) Date of filing: 12.08.2004
(51) Int. Cl.: H01L 21/00

(54) **Apparatus and method for indexing and severing film**

(30) Priority: 14.08.2003 US 642835
(71) Applicant: ASM Assembly Automation Ltd., Kwai Chung, Hong Kong (CN)
(72) Inventor: Au, Yuk Cheung, Kwai Chung, Hong Kong (CN); Lau, Siu Wing, Kwai Chung, Hong Kong (CN); Cheung, Yiu Ming, Mei Foo Sun Chuen, Kowloon, Hong Kong (CN); Chong, Chi Ming, Carado Garden, New Territories, Hong Kong (CN); Lo, Wan Wah, Kwai Chung, Hong Kong (CN)
(74) Representative: Griebling, Onno

(57) **Abstract**

The invention provides an apparatus and method for indexing a length of film for severance. The apparatus comprises a linear feeding device operative to hold the film and to feed a predetermined amount of film to a trimming device by moving linearly between an initial position and another position towards the trimming device. A film holder located between the linear feeding device and the trimming device is operable between a first position wherein a gap is provided for the film to pass through during feeding to the trimming device, and a second position for clamping the film when severing the film with the trimming device.

## Description

### Field of the Invention

The invention relates to the indexing of a length of film for trimming, and severing the film after it has been indexed, for transfer and placement onto an object surface.

### Background and Prior Art

Stacked dice are becoming more common in the semiconductor manufacturing industry. Its advantage lies in the fact that stacked dice incorporate more silicon functionality by stacking multiple dice into a single package. This reduces overall size by eliminating additional packages on the circuit board. Furthermore, it increases space savings while enhancing electrical performance by reducing propagation time for signals to traverse from one chip to another.

In order to manufacture stacked dice, an adhesive is usually used to stick adjacent dice together. Traditionally, adhesive in the form of epoxy is used to serve this function as well as to act as a spacer. However, more recently, an adhesive in the form of a film made of an elastomeric material has been introduced. It also serves the function of adhering adjacent dice together and spacing them apart. This adhesive film is generally provided in reel form, and an efficient and accurate apparatus and method is required to index and sever such film fed from a reel.

In US Patent Application Number 2002/0109217A1 for an "Apparatus for Die Bonding", a set of rollers are used for feeding the film to a cutting or trimming device. Feeding force is provided by friction between the film and the rollers, together with rotation of the rollers. A problem with using rollers to feed the film is that there may be an error in converting rotational motion of the rollers to linear output for indexing. This error in conversion means that the system cannot easily achieve a high resolution and level of accuracy. This may lead to non-uniformity in different pieces of adhesive film that are trimmed, reducing accurate repeatability of the process. Moreover, the prior art apparatus is not adapted to control the film located in a gap between the adhesive film and a trimming device. As a result, extensive burr is formed at the cut film edge.

### Summary of the Invention

It is an object of the invention to seek to provide an improved apparatus and method for indexing and severing film that avoids some of the disadvantages identified in the aforementioned prior art.

According to a first aspect of the invention, there is provided an apparatus for indexing a length of film for severance comprising: a linear feeding device operative to hold the film and to feed a predetermined amount of film to a trimming device by moving linearly between an initial position and another position towards the trimming device; and a film holder between the linear feeding device and the trimming device that is operable between a first position wherein a gap is provided for the film to pass through during feeding to the trimming device, and a second position for clamping the film when severing the film with the trimming device.

According to a second aspect of the invention, there is provided a method for indexing a length of film for severance at a severance position comprising the steps of: providing a linear feeding device at an initial indexing position for holding the film and a gap between the initial indexing position and the severance position for the film to pass through; feeding a predetermined amount of film for severance at the severance position by moving the linear feeding device together with the film linearly towards the severance position; closing the said gap and clamping the film; then severing the predetermined length of film.

It will be convenient to hereinafter describe the invention in greater detail by reference to the accompanying drawings which illustrate one embodiment of the invention. The particularity of the drawings and the related description is not to be understood as superseding the generality of the broad identification of the invention as defined by the claims.

### Brief Description of the Drawings

An example of a preferred embodiment of an apparatus and method in accordance with the invention will now be described with reference to the accompanying drawings, in which:
Figure 1 is a side view illustration of a layout of a prior art film handling apparatus for indexing and severing a length of film;
Figure 2 is an isometric view of a film handling apparatus according to the preferred embodiment of the invention;
Figure 3 is a side view illustration of the layout of the apparatus of figure 2 that is indexing a length of film for trimming; and
Figure 4 is a side view illustration of the layout of the apparatus showing a trimming motion of its trimming device.

### Detailed Description of Preferred Embodiment

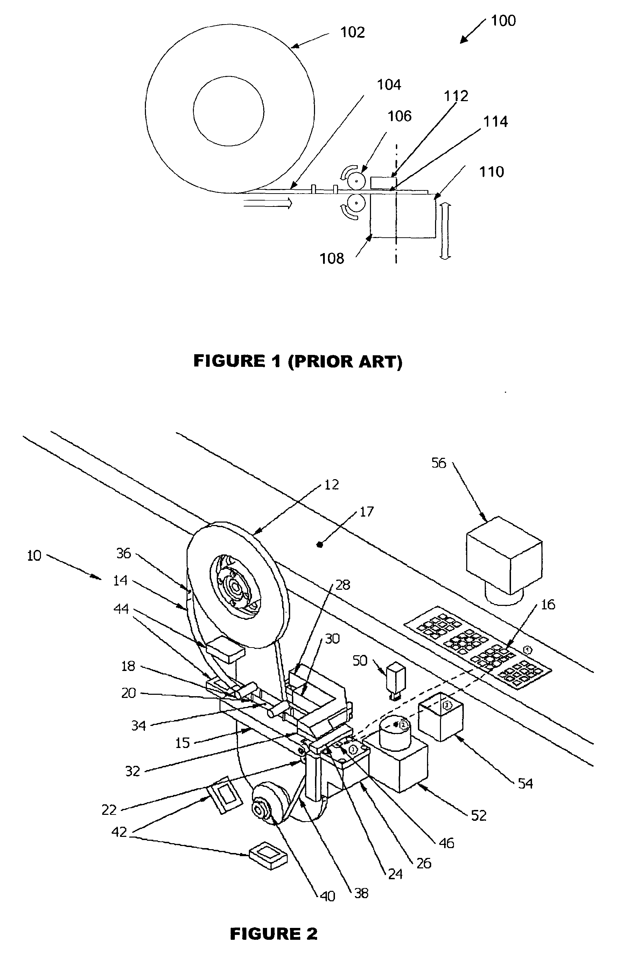

Figure 1 is a side view illustration of a layout of a prior art film handling apparatus 100 for indexing and severing a roll of adhesive film 104. A tape reel 102 is installed on the apparatus 100 and supplies the adhesive film 104 to a fixed platform 108. The film 104 is gripped on both its upper and lower surfaces by film rollers 106 on the fixed platform 108. The film rollers 106 have frictional surfaces to drive the film forward and serve to control feeding of the film 104 to a movable platform 110. The movable platform moves up and down relative to the fixed platform 108 and a trimming support 112. A piece of adhesive film 104 is severed when the movable platform 110 engages and overlaps the trimming support 112 during upwards movement of the movable platform 110.

In the prior art apparatus 100, the use of rollers 106 may result in a conversion error when converting their rotational output to linear output required to index the adhesive film 104. Furthermore, there is usually a tolerance gap 114 that is maintained between the fixed platform 108 and the trimming support 112 to allow the film 104 to slide to the movable platform 110 during indexing. However, this tolerance gap 114 allows slack in the film and movement of the film 104 during trimming. This causes the film 104 to elongate unnecessarily and may result in an undesirable and extensive burr at a severed edge of the film 104. Burr should be reduced so that trimming accuracy is improved.

Figure 2 is an isometric view of a film handling apparatus 10 according to the preferred embodiment of the invention. A film reel 12 is installed on an input reel handler in the apparatus 10, providing film 14, such as adhesive film, that is to be severed or trimmed, transferred and placed onto a substrate 16 located on a work holder 17. Instead of using a set of rollers as in the prior art, a linear feeding device is used to index the film 14 for severance.

The film 14 is extended onto a fixed platform 15 and is generally arranged horizontally on the fixed platform 15 with guiding rollers 18. The guiding rollers 18 do not need to actively drive the film 14 for feeding, but serve as guides to keep the film 14 substantially horizontal on the fixed platform 15. It is also preferable that movement of the film 14 be further restricted by passing it through film width guides 20, which keep a path of the film 14 straight. The film width guides 20 are preferably adjustable to cater for different widths of film 14.

The film 14 is further extended past a film holder 22 that is movable to hold the film 14 firmly during trimming, as will be explained in greater detail below. There is a trimming device comprising a trimming support 24 and a movable platform 26. The trimming support 24 is located over the film holder 22 and there is a gap between the film holder 22 and trimming support 24 for the film 14 to slide during indexing. Adjacent to the film holder 22 is the movable platform 26 that is adapted to move up and down relative to the trimming support 24. When a piece of film 14 is on the movable platform 26 and the movable platform 26 is raised to engage the trimming support 24, and thereafter to overlap the trimming support 24, a piece of film 14 is severed by the trimming device.

For indexing the film 14 relative to the movable platform 26 and trimming support 24, a linear feeding device in the form of a film feeder 28 is provided. The film feeder 28 has a linear driving mechanism that is adapted to move forwards and backwards in a horizontal motion along the surface of the fixed platform 15 from an initial position towards the movable platform 26. Preferably, it comprises a vacuum head coupled to a vacuum suction device. It uses vacuum suction to hold the strip of film 14 and feed a required length of film 14 towards the movable platform 26 during indexing. A preferred action is to slide the film feeder 28 along the top surface of the fixed platform 15 supporting the film 14. Thereafter, the vacuum suction is switched off as the film feeder 28 moves back to its initial position after indexing. To enhance vacuum suction, a vacuum head with a patterned interface, which may be in the form of a series of patterns, is used for the film feeder 28. This vacuum head patterned interface is changeable for different types of film.

A linear encoder 30 associated with or coupled to the film feeder 28 may determined a position of the film feeder 28 by relaying positional information of the film feeder 28 to a processor for positional feedback and controlling movement of the film feeder 28. This allows higher accuracy and more precise indexing. It is preferable that the film feeder 28 has a surface that is made of material that has low static generation with the film, such as a Teflon surface 32 to contact the film 14. The Teflon surface 32 assists the film feeder 28 in sliding over the film 14 without pulling the film when the vacuum suction is turned off and it moves towards its initial position.

In order to allow the apparatus 10 to detect that the reel of film 14 has been used up and to stop feeding film, there is an end-of-film sensor 34 located on the fixed platform 15. The end-of-film sensor 34 takes advantage of the fact that there is usually a corresponding end-of-film indicator on the film reel, for example, an end-of-film hole 36, to denote an exhaustion of a film reel 12. Therefore, the apparatus 10 is adapted to stop functioning and an alarm may be sounded to request a change of film reel 12 when this happens.

Furthermore, a film reel 12 that provides adhesive film usually also provides an adhesive film 14 with a protective backing cover 38 on one or both surfaces of the adhesive film 14. Hence, a peeling device should be included to peel the backing cover 38 off the adhesive film 14 prior to trimming. This may be achieved by coupling backing cover 38 peeled off from the film 14 to a collecting reel 40. In the preferred embodiment, there is only one layer of protective cover 38, and this is peeled away from the adhesive film 14 just before the film holder 22. The protective cover 38 is fed into and collected by the collecting reel 40 located below the fixed platform 15. The collecting reel 40 is preferably driven to actively peel the protective cover 38 from the adhesive film 14 as it is fed towards the movable platform 26 for trimming. Preferably, there are reel collecting sensors 42 placed next to the collecting reel 40 so as to detect when the collecting reel 40 is full and needs to be replaced. The reel collecting sensors 42 also indicate when to turn on the collecting reel 40 motor to collect more backing cover 38, since when excess backing cover 38 is separated from the adhesive film 14, it loops closer to and may thus trigger the lower reel collecting sensor 42.

Another feature of the apparatus 10 is that some slack should be maintained in the film 14 between the film reel 12 and the fixed platform 15. To do this, the film 14 is fed as a loop to the fixed platform 15. A pair of reel feeding sensors 44 may be placed facing each other with the film 14 in between to ensure that the loop is maintained. Thus, there is a top sensor and a bottom sensor. The reel feeding sensors 44 may be positioned such that at particular positions of the film 14 leaving the film reel 12, for example if the film 14 is too close to the top sensor 44, the apparatus 10 will generate more film 14 from the film reel 12. Conversely, if the film 14 is too close to the bottom sensor 44, the apparatus 10 will stop generating film 14 from the film reel 12.

A film sensor 46 is located on the movable platform 26 for determining the presence or absence of film 14 on the trimming device. Movement of the movable platform 26 to sever a piece of film 14 may be predicated upon the film sensor 46 sensing the presence of film 14 on it before a trimming action is initiated. When a piece of film 14 has been trimmed and is on the movable platform 26, a pick-up tool 50 is moved over the piece of film 14, and picks up the film by suitable means, such as by vacuum suction. The pick-up tool carries the film 14 over an optical device such as a film inspection camera 52 located between the movable platform 26 and a placement position. Thus, the pick-up tool 50 holds the piece of film on one surface while an opposite surface of the piece of film is inspected. At this point, an image captured by the film inspection camera 52 is processed by an image processor to determine, in particular, whether it is of a correct shape and/or size for attachment to the substrate 16.

If the piece of film 14 is acceptable, it will be carried over to a bonding position of the substrate 16 and be attached. An indexing camera 56 is located over the substrate 16 and bonding position to ensure that the piece of film 14 is correctly placed. If, during inspection by the film inspection camera 52, the piece of film 14 is found to be defective or otherwise does not qualify acceptability criteria, it will instead be dropped into a waste collecting bin 54.

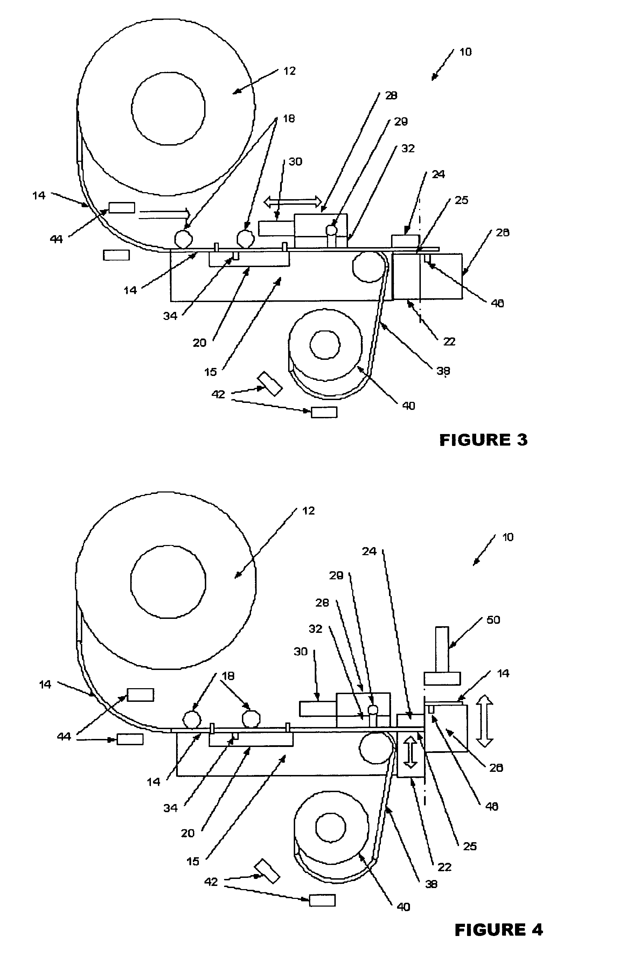

Figure 3 is a side view illustration of the layout of the apparatus 10 of figure 2 that is indexing a length of film 14 for trimming. A vacuum device 29 of the film feeder 28 is turned on, and the length of film 14 is held by the film feeder 28. From its initial position, the film feeder 28 will move towards the movable platform 26 bringing the film 14 with it. There is a tolerance gap 25 between the film holder 22 and the trimming support 24 to allow the film 14 to pass through the gap 25. The linear encoder 30 indicates when an end of an indexing position is reached so that the film feeder 28 stops and the vacuum device 29 is switched off. There should now be an appropriate length of film 14 over the movable platform 26 for trimming. At the same time, the collecting reel 40 may be driven to peel off protective backing cover 38 from the film 14.

Figure 4 is a side view illustration of the layout of the apparatus 10 showing a trimming motion of its trimming device. The film holder 22 is located between the film feeder 28 and the movable platform 26, and is operable between a first position wherein a gap is provided for the film 14 to pass through during feeding to the movable platform 26 and a second position from clamping the film 14 when severing the film 14. Once an appropriate length of film 14 has been fed, the film holder 22 moves up to clamp the film 14 between the film holder 22 and the trimming support 24. With the film 14 secured, the movable platform 26 engages the trimming support 24 and overlaps it, as shown in figure 4. Movement of the film holder 22 and movable platform 26 may be synchronized so that they move up together, or movement may be successive. In either case, the tolerance gap 25 is closed during trimming. The interaction between the movable platform 26 and trimming support 24 severs a piece of film 14 for pick-up and attachment by the pick-up tool 50.

With this process, the film edge is held firmly and is elongated during trimming for a shorter time. This helps to reduce the burr length of the film edge. There is no movement along any direction and less distortion is found at a corner of the film during trimming since the film 14 is held firmly.

At the same time, after the vacuum device 29 is switched off, the film feeder 28 is moved back horizontally to its initial position. The Teflon surface 32 of the film feeder 28 assists it in moving backwards without pulling on the film 14. Moreover, the film holder 22 is still holding onto the film 14 as the film feeder 28 moves backwards to get ready for the next indexing cycle of the film 14. Thus, misalignment of the film 14 is avoided during backwards movement of the film feeder 28. Thereafter, the film holder 22 is moved down again to leave a tolerance gap 25 for a further length of film 14 to be fed in the next indexing cycle.

The invention described herein is susceptible to variations, modifications and/or additions other than those specifically described and it is to be understood that the invention includes all such variations, modifications and/or additions which fall within the spirit and scope of the above description.

## Claims

1. An apparatus for indexing a length of film for severance comprising:
a linear feeding device operative to hold the film and to feed a predetermined amount of film to a trimming device by moving linearly between an initial position and another position towards the trimming device; and
a film holder between the linear feeding device and the trimming device that is operable between a first position wherein a gap is provided for the film to pass through during feeding to the trimming device, and a second position for clamping the film when severing the film with the trimming device.

2. An apparatus as claimed in claim 1, wherein the linear feeding device comprises a vacuum head coupled to a vacuum suction device.

3. An apparatus as claimed in claim 2, wherein the vacuum head has a patterned interface, and said interface is changeable for different types of film.

4. An apparatus as claimed in claim 2 or claim 3, wherein a surface of the linear feeding device contacting the film is made from material that has low static generation with the film.

5. An apparatus as claimed in any one of the preceding claims, including a linear encoder coupled to the linear feeding device for determining a position of the linear feeding device.

6. An apparatus as claimed in any one of the preceding claims, including a film reel for supplying the length of film, and sensors positioned adjacent to the film reel operative to activate the film reel to release film at particular positions of the film with respect to the sensors, whereby a loop is maintainable between the film reel and a surface supporting the film for indexing.

7. An apparatus as claimed in claim 6, including one or more rollers situated between the film reel and the linear feeding device to bring the film substantially level with the said surface supporting the film.

8. An apparatus as claimed in any one of the preceding claims, including a collecting reel to which a backing cover peeled off from the film is coupled, for collecting backing cover peeled off from the film during indexing.

9. An apparatus as claimed in claim 8, including collecting sensors adjacent to the backing cover that is operative to initiate driving of the collecting reel for collecting further backing cover from the film.

10. An apparatus as claimed in any one of the preceding claims, including a pick-up device movable between the trimming device and a placement position, and an optical device positionable under the pick-up device for inspecting a piece of film on the pick-up device.

11. An apparatus as claimed in any one of the preceding claims, including a film sensor situated on the trimming device for detecting a presence of a length of film and for initiating a trimming action to sever the same.

12. An apparatus as claimed in any one of the preceding claims, including an end-of-film sensor on the apparatus for detecting an end of a length of film and initiating an action to stop feeding film to the trimming device.

13. A method for indexing a length of film for severance at a severance position comprising the steps of:
providing a linear feeding device at an initial indexing position for holding the film and a gap between the initial indexing position and the severance position for the film to pass through;
feeding a predetermined amount of film for severance at the severance position by moving the linear feeding device together with the film linearly towards the severance position;
closing the said gap and clamping the film; then
severing the predetermined length of film.

14. A method as claimed in claim 13, wherein the step of holding the film comprises activating a vacuum suction source coupled to the linear feeding device for applying a holding pressure onto the film.

15. A method as claimed in claim 14, including deactivating the vacuum suction source to release the film after clamping the film.

16. A method as claimed in any one of claims 13 to 15, wherein moving the linear feeding device linearly comprises sliding the linear feeding device along a surface supporting the film.

17. A method as claimed in any one of claims 13 to 16, further including the step of moving the linear feeding device linearly to its initial indexing position after clamping the film.

18. A method as claimed in any one of claims 13 to 17, including maintaining a loop in the film between a supply of film and a surface supporting the film for indexing.

19. A method as claimed in claim 17 or claim 18, including maintaining a portion of the film to be held by the linear feeding device substantially level with the said surface supporting the film.

20. A method as claimed in any one of claims 13 to 19, including picking up a piece of film that has been severed by holding it on one surface, and inspecting an opposite surface of the piece of film with an optical device before it is placed onto a placement surface.
